## Europäisches Patentamt
## European Patent Office
## Office européen des brevets

(19)

(11) Veröffentlichungsnummer: **0 013 877**
**B1**

(12) **EUROPÄISCHE PATENTSCHRIFT**

(45) Veröffentlichungstag der Patentschrift: **22.06.83**

(21) Anmeldenummer: **80100018.3**

(22) Anmeldetag: **03.01.80**

(51) Int. Cl.³: **H 01 R 43/00,**
**G 01 R 31/04,**
**G 01 M 19/00, G 01 L 5/00**

(54) Verfahren und Vorrichtung zum Prüfen einer Klammer einer lötfreien elektrischen Verbindung.

(30) Priorität: **24.01.79 DE 2902696**

(43) Veröffentlichungstag der Anmeldung:
**06.08.80 Patentblatt 80/16**

(45) Bekanntmachung des Hinweises auf die Patenterteilung:
**22.06.83 Patentblatt 83/25**

(84) Benannte Vertragsstaaten:
**BE FR GB IT NL**

(56) Entgegenhaltungen:
**Deutsche Industrie Norme (DIN) 41611**

(73) Patentinhaber: **SIEMENS AKTIENGESELLSCHAFT**
**Berlin und München Wittelsbacherplatz 2**
**D-8000 München 2 (DE)**

(72) Erfinder: **Seitz, Max, Dipl.-Ing.**
**Autharistrasse 36**
**D-8000 München 90 (DE)**
Erfinder: **Thumm, Hans-Peter**
**Allgäuerstrasse 85**
**D-8000 München 71 (DE)**
Erfinder: **Hagen, Günther, Dipl.-Ing.**
**Georgenstrasse 58**
**D-8000 München 40 (DE)**
Erfinder: **Grad, Gerald**
**Autharistrasse 7**
**D-8000 München 90 (DE)**

Verfahren und Vorrichtung zum Prüfen einer Klammer einer lötfreien elektrischen Verbindung

Die Erfindung bezieht sich auf ein Verfahren zum Prüfen einer Klammer einer lötfreien elektrischen Verbindung, die zusammen mit einem abisolierten Ende eines mehrdrähtigen Leiters auf einen Klammerstift unter Druck aufgeschoben wird, sowie eine Vorrichtung zur Durchführung des Verfahrens.

Lötfreie elektrische Klammerverbindungen dieser Art können bei der Verarbeitung einzelner Schaltdrähte und mehrdrähtiger Leiter eingesetzt werden. Nach DIN 41611 Teil 4 erfolgt das Prüfen solcher Klammerverbindungen mit sog. Abzugsprüfern, mit welchen die Kraft gemessen wird, die nötig ist, um die Klammer auf dem Klammerstift zu bewegen. Dazu wird der Abzugsprüfer hinter der Klammer angesetzt, wobei durch einen Zug axial zum Klammerstift eine geeichte Feder im Griff des Abzugsprüfers gespannt wird. Hierbei darf sich die Klammer bis zu einer durch eine Marke vorgegebenen Kraft nicht verschieben. Es hat sich jedoch gezeigt, daß eine derartige Prüfung bei Klammerverbindungen mit mehrdrähtigen Leitern nicht ausreichend ist, weil nämlich ein Lockern der Klammern unter Umständen dann auftreten kann, wenn der Leiter relativ zu dem Klammerstift bewegt wird. Untersuchungen haben ergeben, daß bei der Verarbeitung mehrdrähtiger Leiter sich die einzelnen Drähte bei der Montage zunächst im Bündel anordnen können, welches später jedoch, vor allem beim Bewegen des Leiters, in sich zusammenfallen kann, wodurch sich die Verbindung so lockern kann, daß die Gasdichtheit nicht mehr gegeben ist. Die Ursache hierfür wird darin gesehen, daß nach dem Aufschieben der Klammer und Bewegen des Leiters, die Elastizität infolge zu geringer Streckgrenze des Materials, nicht mehr ausreicht, um nach zunächst elastischer, dann plastischer Verformung den erforderlichen Klammerdruck ausüben zu können.

Der Erfindung liegt die Aufgabe zugrunde, ein Verfahren und eine Vorrichtung zu schaffen, mit der die spezifischen Eigenschaften einer Klammer, insbesondere im Hinblick auf die zuvor geschilderten Probleme untersucht und überprüft werden können.

Das Verfahren gemäß der Erfindung besteht darin, daß die Klammer um das beim Aufschieben auf den Klammerstift sich ergebende Maß aufgespreizt und danach diese Aufspreizung um einen Betrag zurückgenommen wird, welcher sich aus der Differenz der Durchmesser von Leiterdrahtbündel und Einzeldraht ergibt, und daß in diesem Punkt die Aufspreizkraft in bezug auf eine Mindestkraft überwacht wird.

Mit dem erfindungsgemäßen Verfahren werden also die Verhältnisse simuliert, welche sich bei der Verarbeitung von mehrdrähtigen Leitern ergeben können. Das erfindungsgemäße Verfahren kann in einfacher Weise dadurch realisiert werden, daß die Aufspreizung der Klammer mit Hilfe einer senkrecht auf die Mitte des Bodens der an seinen beiden Schenkelenden aufgehängten Klammer ausgeübten Kraft erfolgt.

Vorzugsweise erfolgt die Aufspreizung der Klammer mit Hilfe eines durch Längsdruck betätigbaren Stempels der senkrecht auf die Mitte des Bodens der an seinen beiden Schenkelenden aufgehängten Klammer drückt, wobei das Maß der Aufspreizung und das Maß der Zurücknahme der Aufspreizung durch entsprechende Wegvorgaben des längs beweglichen Stempels bestimmt sind. Besonders vorteilhaft ist, wenn die zur Aufspreizung der Klammer aufgewendete Kraft laufend gemessen und angezeigt wird. In diesem Falle ist man nicht nur in der Lage, die Aufspreizkraft exakt zu bestimmen, sondern man kann auch die Kennlinie einer Klammer exakt aufnehmen. Aus dieser Kennlinie kann man dann u.a. wieder Rückschlüsse über die Eigenschaften des verwendeten Materials für die Klammer ziehen.

Gemäß der Erfindung ist die Vorrichtung zur Durchführung des Verfahrens dadurch gekennzeichnet, daß zur Halterung der Klammer eine, vorzugsweise doppel-T-förmige, Traverse mit ungleich breiten Tragflächen verwendet ist, wobei sich die breiteren Tragflächen mit ihren Innenseiten auf eine Auflage der Prüfvorrichtung abstützen und die Klammer mit ihren beiden Schenkelenden auf die kürzeren Tragflächen aufgeschoben ist, und daß zur Aufspreizung der Klammer ein schieberförmiger Stempel verwendet ist, der in einem Schlitz senkrecht zu den beiden Tragflächen geführt und mit einer Druckspindel der Prüfvorrichtung in Wirkverbindung bringbar ist.

Vorzugsweise wird der Stempel von einer motorisch angetriebenen Spindel betätigt, wobei in der kraftschlüssigen Verbindung zwischen Stempel und Spindel eine piezoelektrische Druckmeßdose angeordnet ist, deren Ausgangsgröße laufend, vorzugsweise digital, anzeigbar ist.

Weitere Ausgestaltungen der erfindungsgemäßen Vorrichtung ergeben sich aus den abhängigen Ansprüchen.

Anhand der Zeichnung, in der auch ein bevorzugtes Ausführungsbeispiel der Erfindung dargestellt ist, wird das erfindungsgemäße Verfahren näher beschrieben. Es zeigen:

Figur 1 eine schaubildliche Darstellung einer lötfreien elektrischen Klammerverbindung,

Figur 2 einen Schnitt durch diese Verbindung in vergrößerter Darstellung,

Figur 3 eine schematische Darstellung des Prinzips der erfindungsgemäßen Prüfvorrichtung,

Figur 4 eine Kennlinie einer Klammer gemäß Figur 1 bis 3,

Figur 5 eine Ansicht der Prüfvorrichtung und

Figur 6 und 7 zwei Schnittansichten der Prüfaufnahme,

Figur 8 ein Blockschaltbild der Steuerung der Prüfvorrichtung.

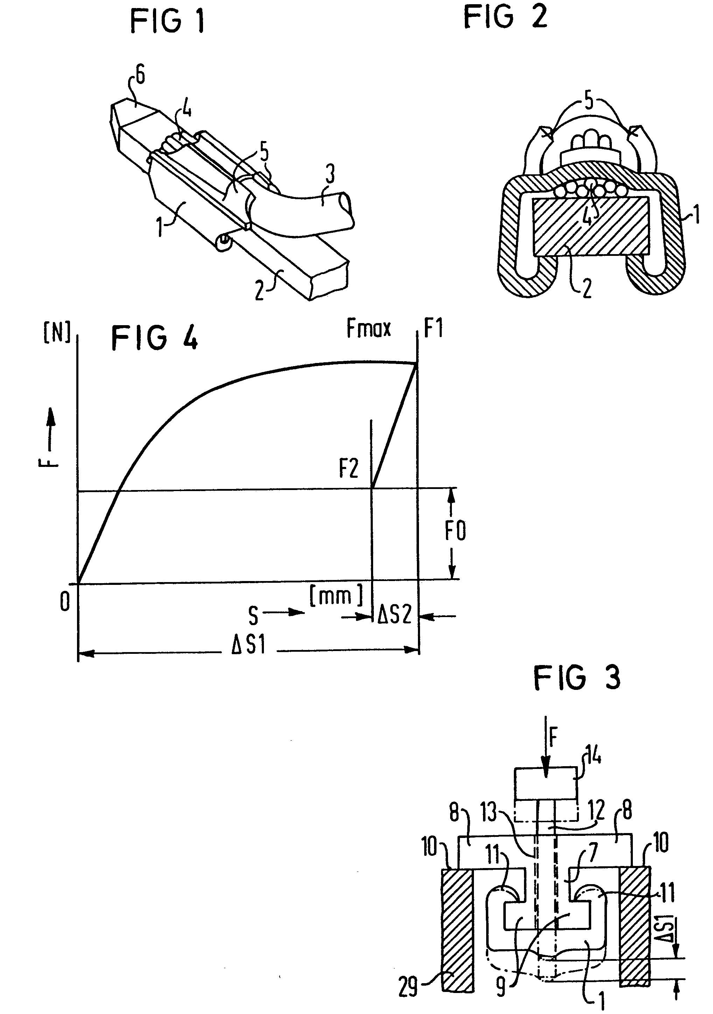

Figur 1 und 2 zeigen die fertigmontierte Klammerverbindung, wobei mit 1 eine Klammer, mit 2 ein Klammerstift und mit 3 ein mehrdrähtiger Leiter bezeichnet sind. Mit 4 sind die einzelnen Drähte des Leiters 3 bezeichnet. Wie Figur 2 zeigt, weist der Leiter 3 sieben Einzeldrähte 4 auf, die mit Hilfe der Klammer 1 gegen den Klammerstift 2 gepreßt werden. An der Klammer 1 sind Laschen 5 angeformt, die den isolierten Leiter 3 so umgreifen, daß eine Zugentlastung derselben stattfindet.

Die Montage einer solchen Klammerverbindung erfolgt in der Regel mit Hilfe einer pistolenartigen Vorrichtung, insbesondere einer Preßluftpistole (siehe Siemens-Prospekt SFR F12-F1545 Nov. 1976 "Klammerverbindung"). Diese weist seitlich eine Offnung auf, in die das noch isolierte Leiterende eingeführt wird. Durch Betätigen des Abzuges der Pistole wird in einem ersten Arbeitsgang das Leiterende abisoliert und mit der Klammer verbunden. Danach wird die Pistole auf die angeschrägte Spitze 6 des Klammerstiftes 2 fest aufgesetzt und fluchtend zum Stift ausgerichtet. In einem nachfolgenden Arbeitsgang wird die Klammer 1 zusammen mit dem abisolierten Leiter auf den Stift unter Druck aufgeschoben. Dabei entstehen hohe spexifische Drücke und eine Verformung des Leiters, welche zu einer innigen und gasdichten Verbindung zwischen Stift und Leiter führen.

Bei dem Aufschiebevorgang selbst wird die Klammer teilweise aufgebogen und plastisch verformt. Dieser Vorgang kann mit einer relativ einfachen Vorrichtung simuliert werden. Figur 3 zeigt im Prinzip die Wirkungsweise einer solchen Vorrichtung. Sie enthält eine Prüfaufnahme, die im wesentlichen aus einer doppel-T-förmigen Traverse 7 mit ungleich breiten Tragflächen 8 und 9 besteht, wobei sich die breiteren Tragflächen 8 mit ihren Innenseiten auf eine Auflagefläche 10 eines Prüfaufnahmeblockes 29 hängend abstützen. Die Klammer 1 ist mit ihren beiden Schenkelenden 11 auf die kürzeren Tragflächen 9 der Traverse 7 aufgeschoben. Die Breite der Tragflächen 9 ist der Klammerbreite entsprechend angepaßt. Zur Simulierung des Aufschiebevorgangs der Klammer 1 auf den Klammerstift 2 wird die Klammer 1 durch eine senkrecht auf die Mitte des Bodens der Klammer 1 wirkende Kraft F belastet. Diese Belastung wird gemäß Figur 3 mit Hilfe eines Stempels 12 ausgeübt, der durch einen Schlitz 13 in der Traverse 7 geführt ist. Hierbei stützt sich das untere Ende des Stempels 12 gegen die Mitte des Bodens der Klammer 1 ab, während das obere Ende des Stempels 12 unter Zwischenschaltung eines Kraftaufnehmers 14 mit einer Kraft F beaufschlagbar ist. Hierbei wirkt der Stempel 12 praktisch in gleicher Weise, als wenn die einzelnen Adern 4 vor dem Aufschieben der Klammer 1 auf den Klammerstift 2 sich im wesentlichen kreisflächenförmig anordnen würden. Die in Figur 2 dargestellte Verteilung der Einzeldrähte 4 des Leiters 3 kann nun in mannigfaltiger Weise stattfinden, wobei im Extremfall bei noch verdrallten Drähten 4 eine annähernd kreisflächenförmige oder elliptische Verteilung vorkommen kann. In diesem Falle besteht dee Gefahr, daß bei Bewegen des Leiters 3 diese Drahtbündel in sich zusammenfällt, so daß dann nicht mehr die Gewähr einer festen Verbindung gegeben ist.

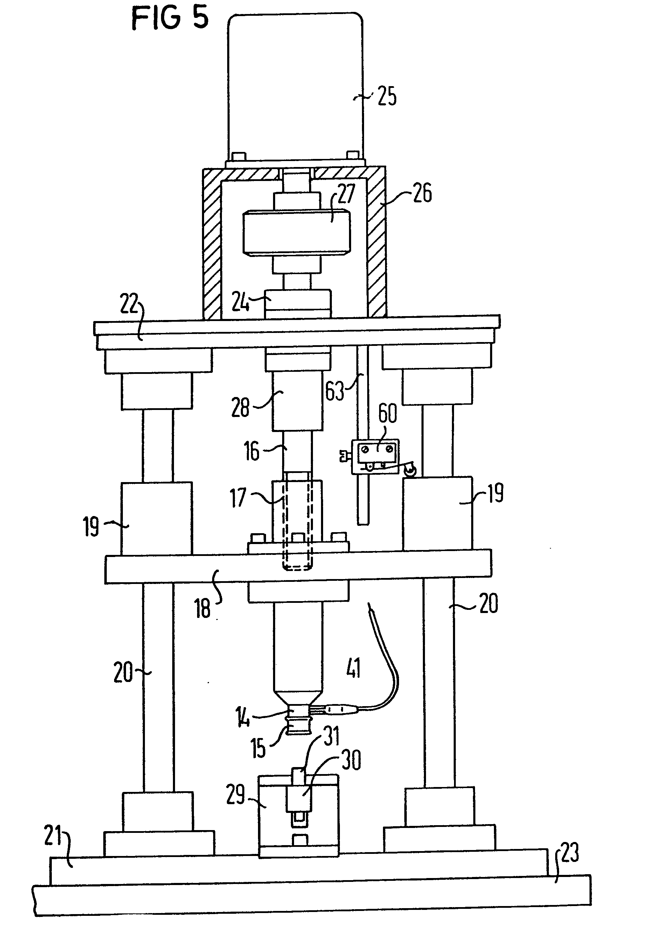

Dieser Vorgang des Zusammenfallens des Drahtbündels wird anhand einer in Figur 4 dargestellten Kennlinie einer Klammer näher erläutert. In diesem Diagramm ist in Abhängigkeit vom Aufspreizweg S die erforderliche Aufspreizkraft F dargestellt. Wie Figur 4 zeigt, steigt die Kennlinie vorerst linear an. Nach Erreichen der Streckgrenze neigt sich die Kennlinie einem Maximum $F_{max}$ zu und fällt dann schließlich in sich zusammen. Wird gemäß Figur 5 die Kraft F von dem Stempel 12 ausgeübt und legt dieser einen Weg $\Delta S1$ zurück, so steigt die Aufspreizkraft F bis zu dem Maximum $F_{max}$ und fällt dann wieder leicht ab zu $F1$. Wird nun der Stempel 12 um die Wegstrecke $\Delta S2$ zurückgenommen, so fällt die Anpreßkraft, die ja der Aufspreizkraft entspricht, auf die Größe $F2$. Der Weg $\Delta S2$ entspricht hier dem vorerwähnten Zusammenfall des Drahtbündels. Dieser Wert ergibt sich rein rechnerisch aus der Differenz des Durchmessers des Leiterdrahtbündels und des Durchmessers eines Einzeldrahtes 4. Es werden also die beiden Extremfälle betrachtet, wobei in dem einen Extremfall die Einzeldrähte 4 ein kreisförmiges Bündel bilden und im anderen Extremfall die Einzelleiter 4 praktisch einlagig zwischen Klammer 1 und Klammerstift 2 anliegen. Solange die Aufspreizkraft $F2$ eine Mindestkraft $FO$ nicht unterschreitet, ist anzunehmen daß die Qualität der Klammerverbindung ausreichend gut ist. Der Wert $\Delta S1$ kann sowohl rechnerisch ermittelt werden, als auch empirisch unter Zugrundelegung der Kennlinie der Klammer gemäß Figur 4. Diese Kennlinie läßt sich mit einer in Figur 5 dargestellten Prüfvorrichtung aufnehmen.

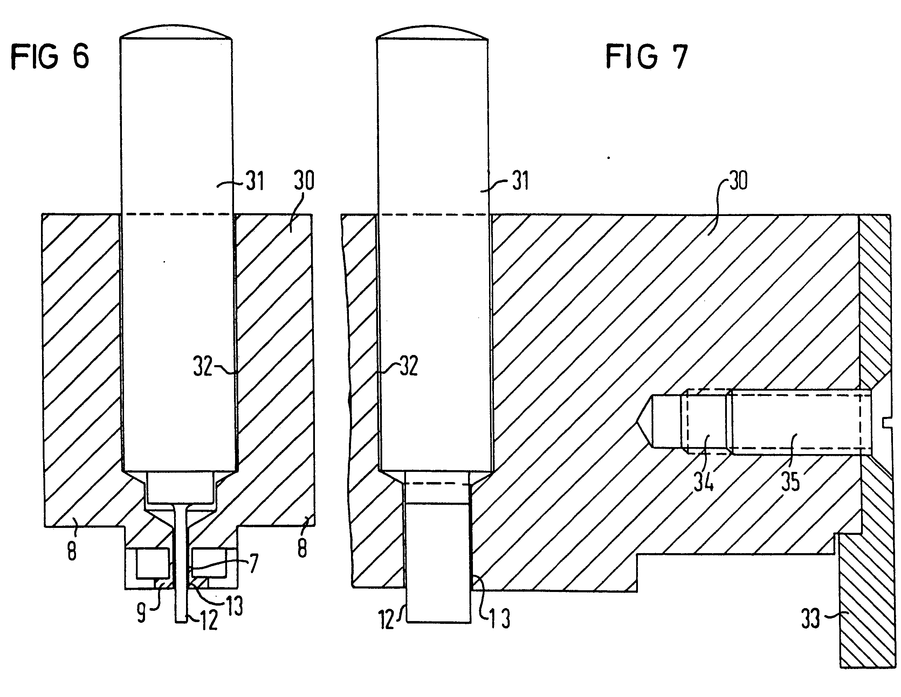

Figur 5 zeigt den prinzipiellen Aufbau einer Vorrichtung zur Durchführung des erfindungsgemäßen Verfahrens. Wirkungsmäßig gleiche Teile sind mit gleichen Bezugszeichen wie zuvor versehen. Vorzugsweise wird als Kraftaufnehmer 14 eine sog. Quarz-Meßunterlagsscheibe verwendet, die den Vorteil hat, daß sie praktisch weglos arbeitet. Der Kraftaufnehmer 14 ist mit einem Druckstück 15 am unteren Ende einer Mutter 17 befestigt, die von einer Spindel 16 in senkrechter Richtung bewegbar ist. Die Mutter 17 ist auf einer Fahrtraverse 18 befestigt, welche mit Hilfe von beidseitig angeordneten Büchsen 19 und Führungssäulen 20 längsverschieblich ist. Die Führungssäulen 20 stützen sich einerseits auf einer Bodentraverse 21 und andererseits auf einer Motortraverse 22 ab. Die Bodentraverse 21 ist auf einer Grundplatte 23 befestigt. Die Motor-Traverse 22 trägt in einer Axiallagerung 24 ein Wellenstück 28, welches als Verlängerung der Spindel 16 den Meßdruck abfängt. Zum anderen stellt das Wellenstück 28 über eine Ausgleichskupplung 27 den Kraftschluß zu einem Motor 25 her. Der Motor 15 selbst ist mittels einer Halterung 26 auf der Motortraverse 22 fixiert. Die Bodentraverse 21 trägt einen Prüfaufnahmebock 29 für die die Klammer 1 haltende Prüfaufnahme 30, die in Figur 6 und 7 näher und in vergrößertem Maßstab dargestellt ist. Mit 31 ist das obere Ende des Prüfstempels 12 bezeichnet.

Wird der vorzugsweise als Schrittmotor ausgebildete Motor 25 an Spannung gelegt bzw. mit Schrittimpulsen versorgt, so wird die Spindel 16 schrittweise über die Kupplung 27 und Wellenstück 28 angetrieben, wobei sich das Druckstück 15 der Mutter mit dem Kraftaufnehmer 14 auf des obere Schaftende 31 des Stempels 12 zubewegt. Durch entsprechende Vor- und Rücklauf-Impulsvorgaben für den Schrittmotor 25 können der Spindel 16 die definierten Wegstrecken ΔS1 bzw. ΔS2 vorgegeben werden.

Figur 6 und 7 zeigen im vergrößerten Maßstab die Prüfaufnahme 30. Die doppel-T-förmige Traverse 7 ist hier aus fertigungstechnischen Gründen an der Prüfaufnahme 30 angeformt. Auf die kürzeren Tragflächen 9 der Traverse 7 wird die zu prüfende Klammer geschoben, und zwar so weit, bis sie über die Öffnung 13 für den schieberförmigen Prüfstempel 12 zu liegen kommt. Da die zu prüfende Klammer relativ klein ist, muß auch der schieberförmige Stempel 12 entsprechend bemessen werden. Der Stempel 12 weist daher einen stärkeren Führungsschaft 31 auf, welcher in einer entsprechend ausgebildeten Bohrung 32 der Prüfaufnahme 30 geführt ist. Ein Winkelstück 33, das stirnseitig mit Hilfe eines Gewindes 34 und einer Schraube 35 auf dem Teil 30 befestigt ist, ergibt eine geeignete Handhabe. Die Prüfaufnahme 30 ist in eine entsprechende Ausnehmung der Auflage 29 einschiebbar, wie Figur 5 zeigt.

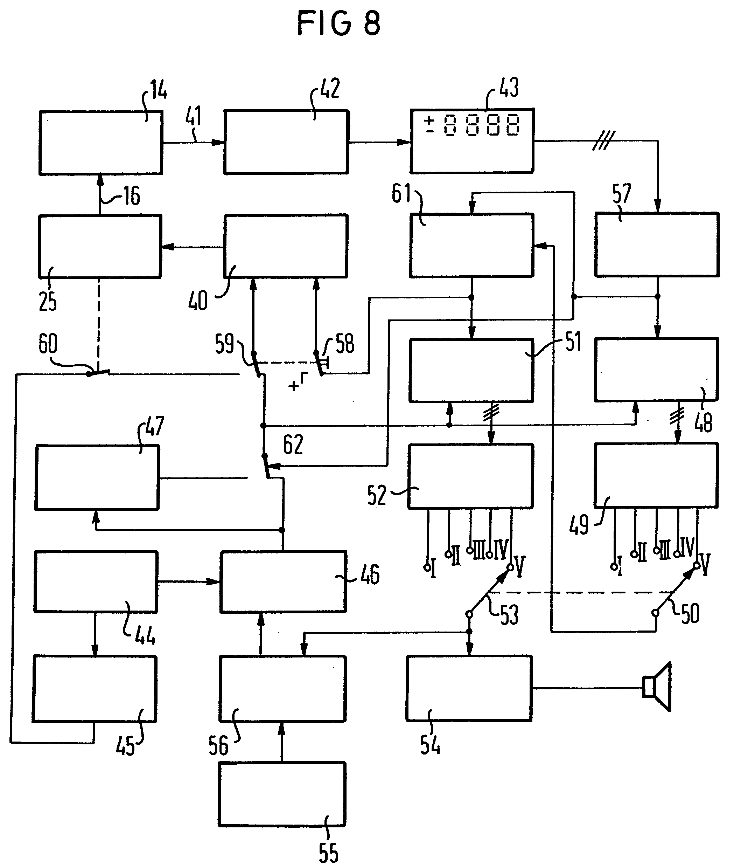

Figur 8 zeigt ein Blockschaltbild der Steuerung der Prüfvorrichtung. Mit 25 ist der Schrittmotor bezeichnet, der über eine Steuerschaltung 40 seine Steuersignale erhält. Der Motor 25 treibt die Gewindespindel 16 an, welche über den Kraftaufnehmer 14 auf den Schaft 31 von Stempel 12 wirkt. Mit dem Kraftaufnehmer 14 ist über eine Leitung 41 gemäß Figur 5 ein Ladungsverstärker 42 verbunden, mit dessen Hilfe der Druck durch ein Digitalvoltmeter 43 angezeigt werden kann.

Nach Betätigen eines Startschalters 55 wird ein Flip-Flop 56 gesetzt, welches die Steuerung freigibt. Der Schrittmotor erhält seine Steuerimpulse von einem Taktgeber 44 über zwei 2:1-Teiler 45 und 46 zum schnellen Vor- und Rücklauf sowie über einen 50:1-Teiler 47 für den Arbeitsvorschub. Zum Einstellen des Spindelweges ΔS1 gemäß Figur 4 dient ein Vorlaufzähler 48, wobei mit Hilfe eines fest verdrahteten Decoders 49 und eines Wahlschalters 50 verschiedene, den Klammerngrößen angepaßte Werte vorgebbar sind. In entsprechender Weise ist ein Rücklaufzähler 51 vorgesehen, der einen Decoder 52 und einen Wahlschalter 53 aufweist. Mit 54 ist eine akustische Anzeige vorgesehen, die anzeigt, wenn der für die Beurteilung maßgebende Ablesezeitpunkt erreicht ist.

Das Digitalvoltmeter 43 steht mit einer Null-Abfrage 57 in Verbindung, die den Vorlaufzähler 48 freigibt, wenn der Null-Punkt der Kennlinie gemäß Figur 4 erreicht ist. Sobald sich also ein Druck aufbaut, wird der Vorlaufzähler 48 freigegeben. Mit 58 ist noch eine Rücklauftaste bezeichnet, mit der ein Schaltkontakt 59 umgelegt werden kann, damit der Schrittmotor 25 über die Steuerschaltung 40 im Eilgang zurückgefahren werden kann. In diesem Fall erhält der Schrittmotor 25 seine Steuerimpulse via den Endtaster 60 und den Teiler 45 vom Taktgeber 44. Ist seine Ausgangsstellung erreicht, wird der Endtaster 60 betätigt, so daß der Schrittmotor keine Steuerimpulse mehr erhält. Der Endtaster 60 ist gemäß Figur 5 auf einen an der Motortraverse 22 befestigten Stab 63 höhenverstellbar befestigt.

Von der Null-Abfrage 57 wird ferner noch ein Flip-Flop 61 und eine Geschwindigkeitsumschalteinrichtung 62 betätigt. Die Geschwindigkeitsumschalteinrichtung 62 ist der Übersicht halber als Schaltkontakt dargestellt. Sobald die Null-Abfrage 57 feststellt, daß der Null-Punkt der Kennlinie gemäß Figur 4 erreicht ist, werden der Vorlaufzähler 48 eingeschaltet und über die Geschwindigkeitsumschalteinrichtung 62 der Langsamgang über den Teiler 47 eingeschaltet.

Die Stellung der Schaltontakte 58 bis 62 ist so dargestellt, als obgerade ein Prüfvorgang zu Ende gegangen ist. Nach der Ablesung der zu überwachenden Aufspreizkraft an dem Digitalvoltmeter 43 wird die Rücklauftaste 58, 59 betätigt. Über Kontakt 58 wird der Steuerschaltung 40 das entsprechende Drehrichtungssignal zugeführt, während sie über Kontakt 59, Endtaster 60, Teiler 45 vom Taktgeber 44 Steuerimpulse zur Rückführung des Antriebmotors 25 in seine Ausgangsstellung erhält. Da nur der 2:1-Teiler 45 eingeschaltet ist, erreicht der Schrittmotor 25 eine sehr hohe Drehzahl. In der Ausgangsstellung der Traverse 18 wird der Endtaster 60 betätigt und damit der Motor 25 stillgesetzt. Nach Entnahme der Prüfaufnahme 30 aus dem Prüfaufnahmebock 29 wird die geprüfte Klammer entfernt und durch eine neu zu prüfende ersetzt. Nach Einsetzen der Prüfaufnahme 30 in den Prüfaufnahmebock wird der Startschalter 55 betätigt. Dieser setzt das Flip-Flop 56, wodurch der Teiler 46 zur Wirkung gebracht wird. Der Taktgeber 44 liefert über den Teiler 46, Umschalteinrichtung 62 und Schaltkontakt 59 Steuerimpulse an die Steuerschaltung 40 für den Motor 25. Da der Teiler 46 ebenfalls ein 2:1-Teiler ist, erhält der Schrittmotor 25 Steuerimpulse mit hoher Frequenz, so daß das Druckstück 15 sich mit hoher Geschwindigkeit dem Führungsschaft 31 des Stempels 12 nähert. Sobald das Druckstück 15 gegen den Führungsschaft 31 des Prüfstempels 12 drückt, gibt der Kraftaufnehmer 14 eine Spannung ab, die durch das Digitalvoltmeter 43 angezeigt wird. Sobald also das Digitalvoltmeter 43 einen von Null abweichenden Betrag anzeigt, gibt die Null-Abfrage 57 den Vorlaufzähler 48 frei und betätigt die Geschwindigkeitsumschalteinrichtung 62, so daß nun der Antriebsmotor 25 über den 50:1-Teiler 47 seine Steuerimpulse erhält. Der Schrittmotor wird also im Schleichgang weiterbetrieben. Entsprechend langsam bewegt sich das Druckstück 15 zur Betätigung des Stempels 12. Am Ende des vorgegebenen Vorschubweges ΔS1 wird über das Flip-Flop 61 der Rücklaufzähler 51 freigegeben. Über das Flip-Flop 61 wird aber auch über den Kontakt 58 der Rücklauftaste die Drehrichtung des Schrittmotors geändert, so daß sich nun der Schrittmotor in Gegenrichtung dreht. Nach der im Decoder 52 vorgegebenen Schrittzahl, die dem Weg ΔS2 entspricht, werden über Kontakt 53 einmal das Flip-Flop 56 betätigt und zum anderen eine akustische Anzeige 54 betätigt. Bei Betätigen des Flip-Flops 56 wird der Motor abgeschaltet, so daß das Digitalvoltmeter 43 abgelesen und bewertet werden kann, ob die Kraft F2 größer oder kleiner als die vorgegebene Kraft FO ist. Das Digitalvoltmeter 43 ist vorzugsweise in [N] geeicht.

Am Ende der Ablesung wird erneut die Rücklauttaste 58 betätigt, wodurch der zuvor beschriebene Rücklaufvorgang für den Antriebsmotor 25 ausgelöst wird.

Mit dem Digitalvoltmeter 43 kann noch eine weitere Abfrage verbunden sein, mit der angezeigt wird, ob ein vorgegebener Mindestwert erreicht und/oder überschritten wird.

**Patentansprüche**

1. Verfahren zum Prüfen einer Klammer (1) einer lötfreien elektrischen Verbindung, die zusammen mit einem abisolierten Ende eines mehrdrähtigen Leiters (3) auf einen Klammerstift (2) unter Druck aufgeschoben wird, dadurch gekennzeichnet, daß die Klammer (1) um das beim Aufschieben auf den Klammerstift (2) sich ergebende Maß (ΔS1) aufgespreizt und danach diese Aufspreizung um einen Betrag (ΔS2) zurückgenommen wird, welcher sich aus der Differenz der Durchmesser von Leiterdrahtbündel und Einzeldraht (4) ergibt, und daß in diesem Punkt die Aufspreizkraft (F) in bezug auf eine Mindestkraft überwacht wird.

2. Verfahren nach Anspruch 1, dadurch gekennzeichnet, daß die Aufspreizung der Klammer (1) mit Hilfe eines senkrecht auf die Mitte des Bodens der an seinen beiden Schenkelenden (11) aufgehängten Klammer (1) ausgeübten Kraft (F) erfolgt.

3. Verfahren nach Anspruch 2, dadurch gekennzeichnet, daß die Aufspreizung der Klammer (1) mit Hilfe eines durch eine Längskraft (F) betätigbaren Stempels (12) erfolgt, der senkrecht auf die Mitte des Bodens der an seinen beiden Schenkelenden (11) aufgehängten Klammer (1) drückt.

4. Verfahren nach Anspruch 3, dadurch gekennzeichnet, daß das Maß der Aufspreizung (ΔS1) und das Maß der Zurücknahme (ΔS2) der Aufspreizung durch entsprechende Wegvorgaben des längs beweglichen Stempels (12) bestimmt sind.

5. Verfahren nach einem der Ansprüche 1 bis 4, dadurch gekennzeichnet, daß die zur Aufspreizung der Klammer (1) aufgewendete Kraft (F) laufend gemessen und in N angezeigt wird.

6. Vorrichtung zur Durchführung des Verfahrens nach den Ansprüchen 1 bis 5, dadurch gekennzeichnet, daß zur Halterung der Klammer (1) eine, vorzugsweise doppel-T-förmige, Traverse (7) mit ungleich breiten Tragflächen (8, 9) verwendet ist, wobei sich die breiteren Tragflächen (8) mit ihren Innenseiten auf eine Auflage (10) der Prüfvorrichtung abstützen und die Klammer (1) mit ihren beiden Schenkelenden (11) auf die kürzeren Tragflächen (9) aufgeschoben ist, und daß zur Aufspreizung der Klammer (1) ein schieberförmiger Stempel (12) verwendet ist, der in einem Schlitz (13) senkrecht zu den beiden Tragflächen (8, 9) geführt und mit einer Druckspindel (16) der Prüfvorrichtung in Wirkverbindung bringbar ist.

7. Vorrichtung nach Anspruch 6, dadurch gekennzeichnet, daß der Stempel (12) von einer motorisch angetriebenen Spindel (16) betätigt wird, wobei in der kraftschlüssigen Verbindung zwischen Stempel (12) und Spindel (16) vorzugsweise eine Quarz-Meßunterlagscheibe als Kraftaufnehmer (14) angeordnet ist, deren Ausgangsgröße laufend, vorzugsweise digital, anzeigbar ist.

8. Vorrichtung nach Anspruch 7, dadurch gekennzeichnet, daß der motorische Antrieb (25) der Spindel (16) einen Schnellgang zum Heranführen des Druckstückes an den Stempel (12) aufweist, während der Arbeitsvorschub vom Spreizen der Klammer (1) durch einen Schrittbetrieb des Motors (25) erfolgt.

9. Vorrichtung nach Anspruch 8, dadurch gekennzeichnet, daß der Vorschub- und Rückstellweg (ΔS1 bzw. ΔS2) des Stempels durch Einstellung der Anzahl der Arbeitsschritte des Motors (25) vorwählbar sind.

10. Vorrichtung nach Anspruch 8, dadurch gekennzeichnet, daß am Ende des vorgegebenen Vorschubweges (ΔS1) der Schrittmotor (25) selbsttätig in der Drehrichtung umgeschaltet und am Ende des vorgegebenen Rückstellweges (ΔS2) zum Zwecke des Ablesens der Aufspreizkraft (F) abgeschaltet wird.

11. Vorrichtung nach Anspruch 10, dadurch gekennzeichnet, daß eine Rücklauftaste (58, 59) vorgesehen ist, über die der Motor (25) mit höherer Schaltfrequenz versorgt wird.

12. Vorrichtung nach Ansprüchen 6 bis 11, dadurch gekennzeichnet, daß am Ende des Rückstellweges (ΔS2) ein Signal zur Ablesung ausgelöst wird.

13. Vorrichtung nach einem der Ansprüche 6 bis 12, dadurch gekennzeichnet, daß bei Erreichen und/oder Unterschreiten einer vorgebbaren Mindestkraft (FO) eine entsprechende Anzeige erfolgt.

## Revendications

1. Procédé pour essayer une agrafe (1) d'une liaison électrique sans soudure, qui ensemble avec une extrémité dénudée d'un conducteur à brins multiples (3) est enfilée sous pression sur une tige de blocage (2), caractérisé en ce qu'il consiste à écarter l'agrafe (1) de la valeur (ΔS1) résultant de l'enfilage sur la tige de blocage (2) et ensuite à diminuer cet écartement d'un montant (ΔS2) qui résulte de la différence de diamètre entre le faisceau de brins conducteurs et le brin individuel (4), et à contrôler à cet égard la force d'écartement (F) par rapport à une force minimale.

2. Procédé suivant la revendication 1, caractérisé en ce qu'il consiste à effectuer l'écartement de l'agrafe (1) à l'aide d'une force (F) appliquée verticalement au milieu du fond de l'agrafe (1) suspendue par ses deux ailes d'extrémité (11).

3. Procédé suivant la revendications 2, caractérisé en ce qu'il consiste à effectuer l'écartement de l'agrafe (1) à l'aide d'un poinçon (12), qui peut être actionné par une force longitudinale (F) et qui s'applique verticalement sur le milieu du fond de l'agrafe (1) suspendue par ses deux ailes d'extrémité (11).

4. Procédé suivant la revendication 3, caractérisé en ce qu'il consiste à déterminer la valeur de l'écartement (ΔS1) et la valeur de la diminution de l'écartement (ΔS2) par des prescriptions correspondantes de trajet du poinçon (12) mobile longitudinalement.

5. Procédé suivant l'une des revendications 1 à 4, caractérisé en ce qu'il consiste à mesurer en continu la force (F) utilisée pour l'écartement de l'agrafe (1) et à l'afficher en N.

6. Dispositif pour l'exécution du procédé suivant les revendications 1 à 5, caractérisé en ce qu'une traverse (7), de préférence en forme de double T, ayant des surfaces porteuses (8, 9) de largeur différente est utilisée pour la fixation de l'agrafe (1), les surfaces porteuses (8) les plus larges s'appuyant par leur partie intérieure sur un appui (10) du dispositif d'essai et l'agrafe (1) étant enfilée par ses deux ailes d'extrémité (11) sur les surfaces porteuses (9) les plus courtes, et en ce que pour l'écartement de l'agrafe (1) est utilisé un poinçon (12) en forme de disque, qui est guidé dans une fente (13) perpendiculairement aux deux surfaces porteuses (8, 9) et qui peut être mis en liaison opératoire avec un arbre de poussée (16) du dispositif d'essai.

7. Dispositif suivant la revendication 6, caractérisé en ce que le poinçon (12) est actionné par un arbre (16) entraîné par moteur, une rondelle de mesure en quartz, servant de transducteur de forces (14) et dont la grandeur de sortie peut être affichée, de préférence numériquement, en continu étant interposée dans la liaison par transmission de forces entre le poinçon (12) et l'arbre (16).

8. Dispositif suivant la revendication 7, caractérisé en ce que l'entraînement (25) par moteur de l'arbre (26) présente une avance rapide pour rapprocher la pièce de poussée du poinçon (12), tandis que l'avance de travail depuis l'écartement de l'agrafe (1) s'effectue par un fonctionnement pas-à-pas du moteur (25).

9. Dispositif suivant la revendication 8, caractérisé en ce que les trajets d'avance et de retour (ΔS1 et ΔS2) du poinçon peuvent être choisis à l'avance en réglant le nombre des pas de travail du moteur (25).

10. Dispositif suivant la revendication 8, caractérisé en ce qu'à la fin du trajet d'avance prescrit (ΔS1) le sens de rotation du moteur pas-à-pas (25) s'inverse automatiquement et à la fin du trajet de retour prescrit (ΔS2) le moteur est arrêté en vue de la lecture de la force d'écartement (F).

11. Dispositif suivant la revendication 10, caractérisé en ce qu'il est prévu une touche de marche arrière (58, 59) par laquelle le moteur (25) est alimenté à une fréquence de commutation plus élevée.

12. Dispositif suivant les revendications 6 à 11, caractérisé en ce qu'à la fin du trajet de retour (ΔS2) un signal de lecture est déclenché.

13. Dispositif suivant l'une des revendications 6 à 12, caractérisé en ce que, lorsque l'on atteint une valeur égale et/ou inférieure à une force minimale (FO) qui peut être prescrite, une indication correspondante a lieu.

## Claims

1. Process for checking a clip (1) in a solderless electrical connection which clip, together with a stripped end of a multi-wire conductor, is placed under pressure onto a clip pin (2), characterised in that the clip (1) is expanded by the amount (ΔS1) which results from the application to the clip pin (2) whereupon this expansion is reduced by an amount (ΔS2) which results from the difference between the diameter of the group of conductor wires and the individual wire (4), and that at this point the expansion force (F) is monitored relative to a minimum force.

2. Process as claimed in claim 1, characterised in that the clip (1) is expanded by means of a force (F) which is exerted upon the centre of the base of the clip (1) which is suspended by its two flank ends (11).

3. Process as claimed in claim 2, characterised in that the clip (1) is expanded by means of a ram (12) which can be actuated by a longitudinal force (F) and which presses vertically against the centre of the base of the clip (1) which is suspended by its two flank ends (11).

4. Process as claimed in claim 3, characterised in that the amount of the expansion ($\Delta S1$) and the amount of the reduction ($\Delta S2$) of the expansion are determined by appropriate given movements of the longitudinally movable ram (12).

5. Process as claimed in one of the claims 1 to 4, characterised in that the force (F) which is used to expand the clip (1) is continuously measured and is displayed in N.

6. Device for the implementation of the process claimed in the claims 1 to 5, characterised in that the clip (1) is supported by a crossbar (7) preferably of a double T formation which possesses bearing surfaces (8, 9) which are unequal in width, where the wider bearing surfaces (8) rest by their inner sides on a support (10) of the checking device and by its two flank ends (11) the clip (1) is positioned on to the shorter bearing surfaces (9), and that the clip (1) is expanded by means of a slide like ram (12) which operates in a slot (13) at right angles to the two bearing surfaces (8, 9) and can be actively connected to a pressure spindle (16) which forms part of the checking device.

7. Device as claimed in claim 6, characterised in that the ram (12) is actuated by a motor driven spindle (16), where a quartz crystal measurement support disc is preferably arranged by way of force accommodator (14) in the force locking connection between ram (12) and spindle (16), the output value of which force accommodator can be continuously displayed, preferably in digital form.

8. Device as claimed in claim 7, characterised in that the motor drive (25) of the spindle (16) has a high speed to allow the pressure component to approach the ram (12) whereas the operational feed for the expansion of the clip (1) is effected by a stepped operation of the motor (25).

9. Device as claimed in claim 8, characterised in that the advance and return movements ($\Delta S1$ and $\Delta S2$) of the ram can be selected by setting the number of operating steps of the motor (25).

10. Device as claimed in claim 8, characterised in that at the end of the predetermined advance movement ($\Delta S1$) the stepping motor (25) is automatically switched over in direction of rotation and at the end of the predetermined return movement ($\Delta S2$) is switched off in order to allow the expanding force (F) to be read off.

11. Device as claimed in claim 10, characterised in that a return key (58, 59) is provided which the motor (25) is supplied with a higher switching frequency.

12. Device as claimed in claims 6 to 11, characterised in that at the end of the return movement ($\Delta S2$) a signal for read out is triggered.

13. Device as claimed in one of the claims 6 to 12, characterised in that when a predeterminable minimum force (FO) is reached and/or fallen below, an appropriate display is effected.

FIG 1

FIG 2

FIG 4

FIG 3

FIG 5

FIG 7

FIG 6

# FIG 8